# EUROPÄISCHE PATENTSCHRIFT

(11) **EP 0 239 825 B1**
(45) Veröffentlichungstag und Bekanntmachung des Hinweises auf die Patenterteilung: **25.08.1993**
(21) Anmeldenummer: 87103090.4
(22) Anmeldetag: 04.03.1987
(51) Int. Cl.: H01L 29/52, H01L 27/082, H01L 21/285, H01L 21/82, H01L 21/225

(54) **Verfahren zur Herstellung einer Bipolartransistorstruktur für Höchstgeschwindigkeitsschaltung**
Method for producing a bipolar transistor structure for very high speed switchings
Procédé de fabrication d'une structure de transistor bipolaire pour des couplages à très hautes vitesses

(30) Priorität: 21.03.1986 DE 3609721
(43) Veröffentlichungstag der Anmeldung: 07.10.1987
(73) Patentinhaber: SIEMENS AKTIENGESELLSCHAFT, 80333 München (DE)
(72) Erfinder: Bertagnolli, Emmerich, Dr., D-8000 München 40 (DE); Weger, Peter, Dipl.-Phys., D-8000 München 90 (DE)

(56) Entgegenhaltungen:
- EP-A- 0 002 670
- EP-A- 0 071 494
- EP-A- 0 142 632
- EP-A- 0 145 927
- DE-A- 3 243 059
- IBM TECHNICAL DISCLOSURE BULLETIN, Band 23, Nr. 12, Mai 1981, Seiten 5388-5391, New York, US; C.G. JAMBOTKAR: "High-density, high-performance bipolar technology"

## Beschreibung

Die Erfindung betrifft ein Verfahren zur Herstellung einer Bipolartransistorstruktur.

Der Bereich schneller integrierter Schaltkreise, wie sie in der Datentechnik, Konsumelektronik und Kommunikationstechnik, zum Beispiel für optische Nachrichtenübertragung, erforderlich sind, wird vorwiegend durch Silizium-Bipolartransistoren abgedeckt.

Die Weiterentwicklung erfolgt zu höheren Geschwindigkeiten bei höherem Integrationsgrad und zu kleineren Verlustleistungen. Es besteht deshalb ein großer Bedarf an Herstellungsverfahren, die für sehr schnelle Speicher-, Logik- und Analogschaltkreise geeignet sind.

Neben den konventionellen Herstellungstechniken, die mit justierten Masken arbeiten, existieren bereits eine Reihe von Verfahren, die selbstjustierende Prozeßschritte enthalten und zu Transistoren mit sehr kleinen Schaltzeiten führen.

So ist aus dem Digest of Technical Papers of the 1982 IEEE Solid State Circuits Conference auf den Seiten 242/243 aus einem Bericht von Tang et. al. eine Bipolartransistorstruktur bekannt, bei der der Emitter selbstjustierend zum Basiskontakt hergestellt ist. Die Lithographie der Transistorstruktur von 1,25 µm x 2,5 µm erfolgt durch Elektronenstrahltechnik. Die Bipolartransistorstruktur wird für emittergekoppelte Logikschaltungen verwendet. Der Abstand zwischen Emitter und Basiskontakt beträgt 0,3 µm; die Emitterbreite liegt bei 1.25 µm.

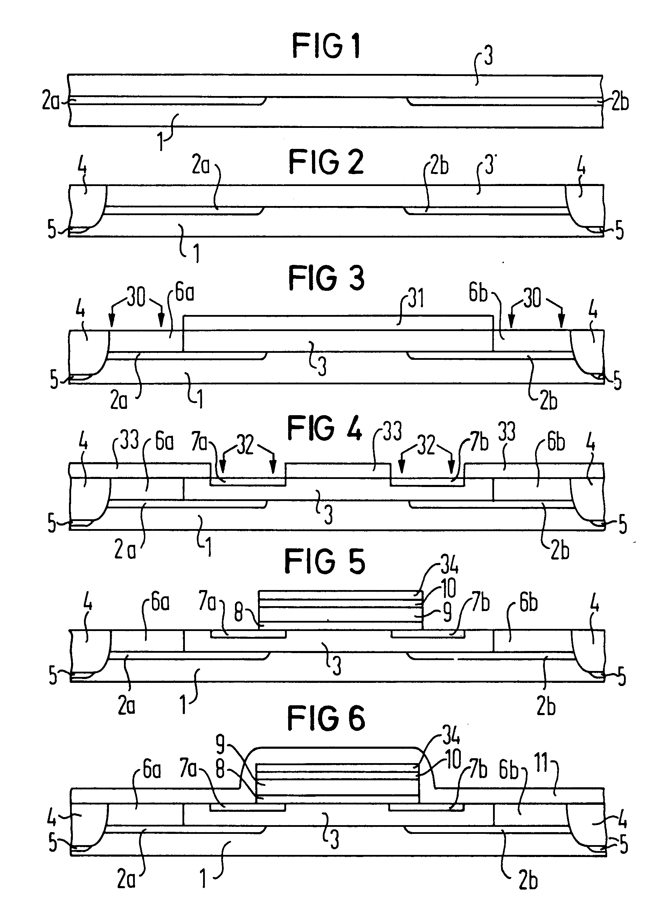

Aus einem Bericht von Konaka et. al. aus den Abstracts of the 16th International Conference on Solid State Devices and Materials, Kobe 1984, ist auf den Seiten 209 bis 212, eine selbstjustierte Bipolartransistorstruktur für Hochgeschwindigkeitsschaltungen (siehe Figur 1B) zu entnehmen, bei der Emitterbreiten von 0,35 µm durch Elektronenstrahllithographie eingestellt werden. Die Emitterzone wird durch Ausdiffusion aus den Emitteranschlußgebieten erzeugt.

Schließlich ist aus einem Bericht von Sang-Hun Chai aus dem Tagungsband von IEDM 1985 ein selbstjustierender Bipolarprozeß bekannt, bei dem der Emitter durch Lithographie definiert ist und die Basiszone aus dem Basisanschluß selbstjustierend unter Verwendung einer vertikalen Nitridmaske erzeugt wird. Der Abstand Emitter-Basis (0,2 µm) wird durch die Schichtdicke der Nitridmaske eingestellt. Es werden sehr schmale Basisanschlußzonen von 0.2 µm erhalten; die Emitterflächen betragen 1,5 µm x 3,0 µm.

Die aus dem Stand der Technik bekannten Verfahren erfordern einen hohen technischen Aufwand für die durchzuführende Lithographie und erlauben trotzdem nicht, die für Höchstgeschwindigkeitsschaltungen notwendigen Emitterbreiten von kleiner 1 µm bei einer akezptablen Ausbeute reproduzierbar einzustellen. Mit den bekannten Techniken ist es überhaupt nicht möglich, weitgehend identische Transistorpaare (mit Emitterbreiten kleiner 1 µm) herzustellen, wie sie für Differenzverstärker mit sehr geringem Offset erforderlich sind.

Folgende gravierende Nachteile müssen bei den bekannten Verfahren in Kauf genommen werden:
1. Die durch die Auflösung der verwendeten Lithographie gegebene Minimalbreite wird durch die bei der Herstellung entstehenden, innenliegenden Flankenisolationen ("spacer") noch zusätzlich vermindert (siehe Berichte von Tang und Konaka). Die bei der Herstellung unvermeidliche Schwankung der spacer-Breite ds bewirkt eine Schwankung der Emitterbreite um das Doppelte, 2 . ds, die Reproduzierbarkeit nimmt bei sehr schmalen Emittern daher stark ab.
2. Die Oberfläche des einkristallinen Emitterbereiches ist mehreren Ätzschritten ausgesetzt, womit immer die Gefahr der Schädigung gegeben ist.
3. Aus naheliegenden Gründen, wie mechanische Spannungen, Kantenbedeckung, thermische Spannungen, ist die spacer-Breite auf Werte kleiner 0,5 µm begrenzt. Daher müssen für Emitterbreiter kleiner 1 µm auch an die Lithographie erhöhte Anforderungen gestellt werden (Minimalbreite kleiner 2 µm erforderlich), was die Verfahren sehr aufwendig macht.

Aus der europäischen Patentanmeldung EP 0 002 670 A1 ist ein Verfahren zum Herstellen eines bipolaren Transistors in einem Halbleitersubstrat bekannt. Dabei wird zur Kontaktierung der Basis an der Oberfläche des Substrats eine erste Schicht aus dotiertem polykristallinem Silizium gebildet und als Basisanschluß strukturiert. An der Oberfläche des Basisanschluß wird durch Oxidation eine isolierende Schicht hergestellt. Über der isolierenden Schicht wird eine zweite dotierte Polysiliziumschicht aufgebracht und als Emitteranschluß strukturiert. Der Dotierstoff aus der zweiten Polysiliziumschicht wird durch Ausdiffusion in das Halbleitersubstrat eingetrieben, um selbstjustiert zum Emitteranschluß einen Emitter zu bilden. Der Abstand zwischen dem Basisanschluß und dem Emitteranschluß ist nur durch die Dicke der isolierenden Schicht bestimmt. Die Emitterweite ist bei diesem Herstellverfahren jedoch abhängig von der Ausdehnung des Emitteranschlusses. Da der Emitteranschluß mit Hilfe einer Maske in einem photolithographischen Verfahren strukturiert wird, ist die Emitterweite von der verwendeten Photolithographie abhängig.

Aus der europäischen Patentanmeldung EP 0 145 927 A1 ist ein Verfahren zur Herstellung eines Feldeffekttransistors bekannt. Dabei wird an der Oberfläche eines Substrats eine Schichtstruktur erzeugt, die an der von dem Substrat abgewandten Seite eine erste leitfähige Schicht umfaßt, die vom Substrat elektrisch isoliert ist. Die Schichtstruktur weist eine zur Oberfläche des Substrats im wesentlichen senkrechte Flanke auf. An der Oberfläche der Schichtstruktur und des Substrats wird eine weitere hochdotierte leitende Schicht konform abgeschieden. Anschließend wird in einem anisotropen Ätzverfahren die konforme, leitfähige Schicht anisotrop geätzt, um die im wesentlichen horizontalen Teile der konformen Schicht zu entfernen, während die vertikalen Teile an der Flanke der Schichtstruktur im wesentlichen bestehen bleiben. Durch Ausdiffusion von Dotierstoff aus den vertikalen Teilen der konformen, leitfähigen Schicht werden Source- bzw. Drain-Gebiete im Substrat erzeugt. Die Ätzresiduen der konformen leitfähigen Schicht und der ersten leitfähigen Schicht des Schichtaufbaus stellen dabei Anschlüsse des Source- bzw. Drain-Gebietes dar.

Die Erfindung dient der Lösung der Aufgabe, Nachteile der bekannten Verfahren zu vermeiden und ein Herstellverfahren für eine Bipolartransistorstruktur anzugeben, mit dem unabhängig von der verwendeten Lithographie vollständig selbstjustierte Transistoren und auch Transistorpaare mit Emitterbreiten kleiner 1 µm, insbesondere kleiner 0,3 µm - was bislang überhaupt noch nicht möglich war -, reproduzierbar hergestellt werden können.

Die erfindungsgemäße Aufgabe wird gelöst durch ein Verfahren nach Anspruch 1.

In einer Weiterbildung des Erfindungsgedankens ist vorgesehen, die als Diffusionsquelle zur Erzeugung der Emitterzonen vorgesehenen, als Teil der Emitteranschlußgebiete dienenden Ätzresiduen aus mit einer n⁺- bzw. p⁺-Dotierung versehenem Polysilizium oder der Kombination Polysilizium/Metallsilizid oder aus dotierten Siliziden hochschmelzender Metalle oder hochschmelzenden Metallen selbst herzustellen.

Es liegt auch im Rahmen der Erfindung, zur Herstellung von Transistorpaaren mit Emitterbreiten kleiner 1 µm die als Diffusionsquellen zur Erzeugung der Emitterzonen dienenden Emitteranschlußgebiete durch einen gemeinsamen Emitteranschluß intern zu verbinden. Desweiteren ist die Möglichkeit gegeben, daß zur Herstellung von bipolaren Transistor-Speicherzellen mit Emitterbreiten kleiner 1 µm die als Diffusionsquellen zur Erzeugung der Emitterzonen dienenden Emitteranschlußgebiete durch einen gemeinsamen Emitteranschluß, der zugleich die eine Speicherelektrode darstellt, intern zu verbinden und pro Speicherzelle nur einen Isolationsring vorzusehen.

Weitere Ausgestaltungen der Erfindung ergeben sich aus den Unteransprüchen.

Im folgenden soll anhand eines Ausführungsbeispiels und der Figuren 1 bis 14 im Schnittbild der erfindungsgemäße Prozeßablauf zur Herstellung einer Bipolartransistorstruktur für npn-Transistoren noch näher beschrieben werden. Eine analoge Herstellung für pnp-Transistoren ist bei Wahl der entsprechenden Dotierung ebenso möglich.

Die Figur 15 zeigt die Bipolartransistorstruktur mit im Gegensatz zu den Figuren 11 bis 14, bei denen der Emitter nach oben kontaktiert ist, seitlich (das heißt in der Zeichenebene) herausgeführtem Emitteranschluß und nach oben kontaktierten Basisanschlüssen.

Die Figur 16 zeigt ein Schnittbild durch ein Transistorpaar mit gemeinsamen Emitteranschluß,
die Figur 17 ein Schnittbild durch eine Speicherzelle, wobei hier die Arbeitswiderstände und Schottkydioden weggelassen werden, da sie ja nicht Gegenstand der Erfindung sind.

Die Figuren 18 bis 21 zeigen Draufsichten auf die Figuren 14, 15, 16 und 17.

Die Figur 22 zeigt das Schaltbild einer Speicherzelle.

In allen Figuren sind für gleiche Teile gleiche Bezugszeichen vorgesehen.

Der besseren Übersicht wegen ist auf die Einzeichnung von Schraffuren für die einzelnen, aus unterschiedlichen Materialien bestehenden Schichten verzichtet worden.

Figur 1: In einem p-dotierten einkristallinen Siliziumsubstrat 1 werden mittels maskierter Ionenimplantation mit zum Beispiel Antimon-Ionen mit einer Dosis und Energie von zum Beispiel 3 x 10¹⁵ cm⁻² und 80 keV n-dotierte Zonen 2a, 2b, welche für den späteren vergrabenen (buried) Kollektor verwendet werden, eingebracht. Dieser Prozeßschritt kann auch entfallen, mit dem Nachteil eines höheren Kollektorwiderstandes. Darauf wird eine n⁻-dotierte epitaktische Siliziumschicht 3 (1 x 10¹⁶ As) in einer Schichtdicke von 0,5 bis 2 µm abgeschieden.

Figur 2: Zur Isolation der aktiven Transistorbereiche werden nun, zum Beispiel durch die Grabenisolationstechnik, wie sie in dem Bericht von Borland im Solid State Technology, August 1985, auf den Seiten 141 bis 148, beschrieben ist, Gräben eingeätzt und mit aus SiO₂ bestehendem Isolationsmaterial aufgefüllt. Es entstehen die Feldoxidbereiche 4. Dabei werden durch eine zusätzliche Bor-Ionenimplantation vor dem Auffüllen der Gräben Kanalstopperbereiche 5 zur Verbesserung der Transistorparameter (Vermeidung eines parasitären Dickoxidtransistors) unter dem Feldoxid 4 erzeugt. Im Prinzip kann jede Isolationstechnik verwendet werden, die die Kollektoren der einzelnen Transistoren voneinander isoliert.

Figur 3: Es erfolgt die Herstellung einer niederohmigen Verbindung 6a, 6b zu den vergrabenen Kollektorzonen 2a, 2b für den tiefreichenden Kollektoranschluß, zum Beispiel durch Ionenimplantation von Phosphor (siehe Pfeile 30) unter Verwendung einer Photolackmaske 31 und anschließendes Eintreiben in einem Temperaturschritt. Dieser Prozeßschritt kann ebenfalls wie in Figur 1 beschrieben durch den Nachteil eines hohen Kollektorwiderstands entfallen.

Figur 4: Die aus p-dotiertem Silizium bestehende Basiszone 7a, 7b wird durch Implantation von Bor-Ionen (siehe Pfeile 32) mit einer Dosis und Energie von zum Beispiel 1 x 10¹³ cm⁻² und 50 keV unter Verwendung einer Photolackmaske 33 erzeugt.

Figur 5: Nun erfolgt die Herstellung einer Schichten folge:
erster Isolator 8, bestehend aus zum Beispiel SiO₂, leitfähige Schicht 9, bestehend aus zum Beispiel Polysilizium mit n⁺-Dotierung,
zweiter Isolator 10, bestehend aus zum Beispiel SiO₂ und dritter Isolator 34, bestehend aus Siliziumnitrid. Diese Isolatorschicht kann auch entfallen. Die leitfähige Schicht 9 hat die Funktion, den späteren Emitteranschluß zu bilden und die Isolatorschicht 34 die Funktion einer Schutzschicht. Die Vierfach-Schichtenfolge 8, 9, 10, 34 wird durch einen anisotropen Ätzprozeß (Trockenätzprozeß durch reaktives Ionenätzen mit Ätzstop der letzten Schicht 8 auf dem einkristallinen Silizium) mittels einer Ätzmaske so strukturiert, daß die Schichtenfolge das Substrat im Bereich des späteren Emitteranschlußgebietes abdeckt.

Figur 6: An dieser Stelle beginnt der erfindungswesentliche Schritt der Erzeugung der schmalen Emitterzone durch Abscheidung einer gut kantenbedeckenden, leitfähigen und als Diffusionsquelle verwendbaren Schicht 11 aus zum Beispiel mit einer n⁺-Dotierung versehenem Polysilizium. Bei der Abscheidung wird die Schichtdicke der Schicht 11 der Breite der gewünschten Emitterzone angepaßt.

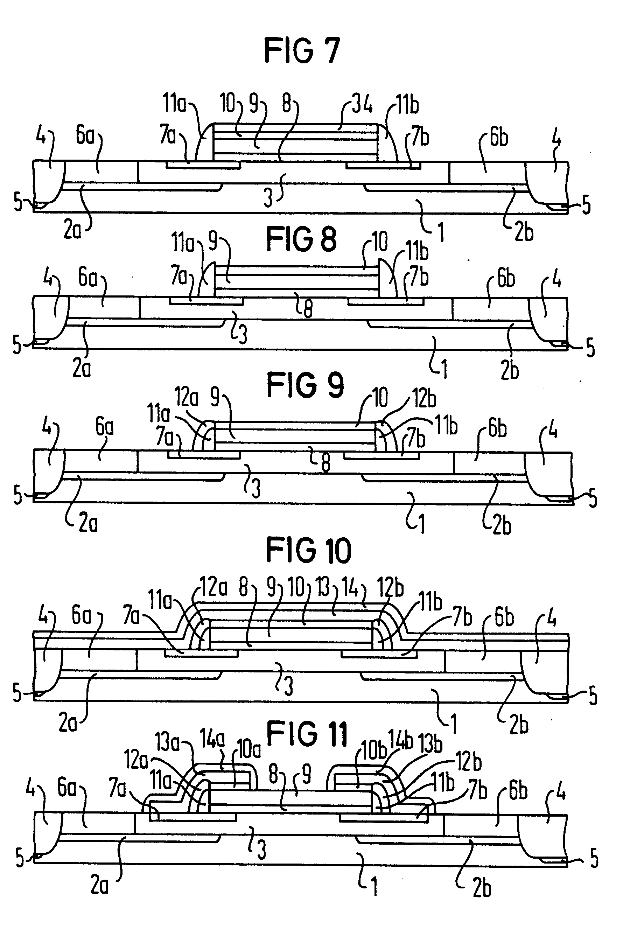

Figur 7: Die Schicht 11 wird ganzflächig durch anisotrope Ätzung (zum Beispiel Trockenätzprozeß) zurückgeätzt, so daß nur die an den Flanken der Schichtenfolgenstruktur 8, 9, 10, 34 bestehenden Ätzresiduen 11a, 11b (sogenannte "spacer") zurückbleiben. Die über die Schichtdicke der Schicht 11 einstellbare spacer-Breite (11a, 11b) bestimmt die Emitterbreite, die, da die Schichtdicke genau einstellbar ist und der Ätzprozeß definiert durchführbar ist, gut reproduzierbar ist.

Figur 8: Die dritte Isolatorschicht 34 aus Siliziumnitrid wird naßchemisch entfernt.

Figur 9: Nun werden die spacer 11a, 11b mit Isolationsschicht-spacern 12a, 12b versehen, in dem die Oberfläche der n⁺-dotierten Polysiliziumschichtstrukturen 11a, 11b und das einkristalline Siliziumsubstrat einer selektiven thermischen Oxidation ausgesetzt werden und eine anisotrope Rückätzung, zum Beispiel durch Trockenätzung, durchgeführt wird. Die Breite der Isolationsspacer 12a, 12b kann gegebenenfalls durch einen zusätzlichen Isolationsspacer (nicht dargestellt) beliebig eingestellt werden.

Figur 10: Auf die mit den "spacern" 11a, 11b, 12a, 12b versehene Anordnung wird ganzflächig zuerst eine leitfähige und als Diffusionsquelle verwendbare Schicht 13 aus zum Beispiel mit einer p⁺-Dotierung versehenem Polysilizium oder Metallsilizid (Tantaldisilizid) und dann eine Isolationsschicht 14 aus zum Beispiel SiO₂ aufgebracht.

Figur 11: Diese Doppelschicht 13, 14 wird durch einen anisotropen Ätzprozeß so strukturiert, daß die Kollektoranschlußbereiche 6a, 6b, die Feldoxidbereiche 4 und der Emitteranschlußbereich 9 freigelegt werden. Im Anschluß daran werden wieder, wie bereits beschrieben, durch ganzflächige Abscheidung und Rückätzen an den Flanken der geätzten Strukturen (10a, 10b, 13a, 13b, 14a, 14b) zur Isolation der Schichtstrukturen 13a, 13b spacer erzeugt.

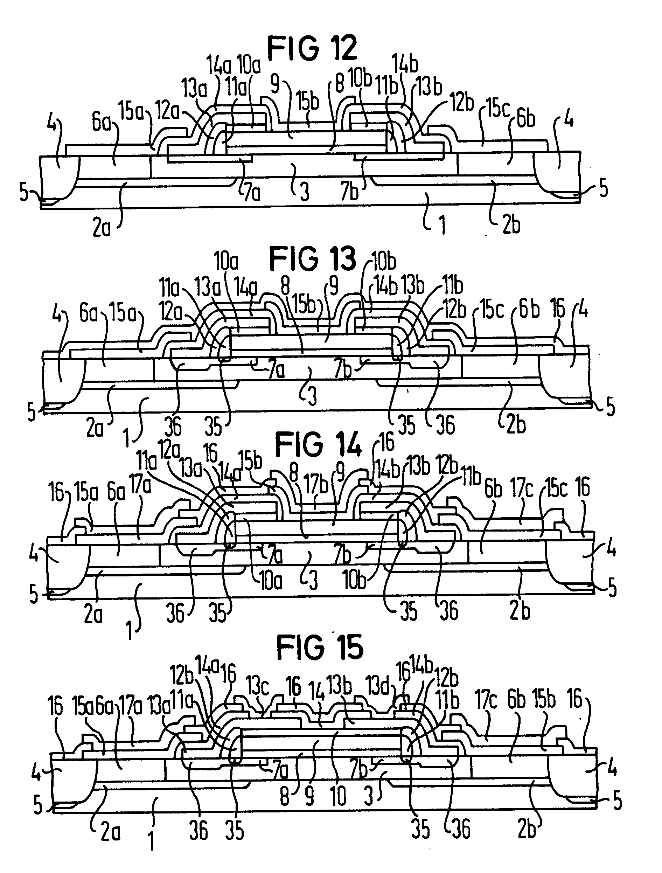

Figur 12: Es erfolgt die ganzflächige Abscheidung und Strukturierung einer n⁺-leitfähigen Schicht 15a, 15b, 15c aus zum Beispiel Tantaldisilizid, wobei die Kollektoranschlüsse 15a, 15c und der Emitteranschluß 15b gebildet werden. Der Basisanschluß wird seitlich herausgeführt (eine Variante dazu siehe Figur 15). An dieser Stelle könnte auch schon die erste Metallisierung aufgebracht werden, wenn vorher die entsprechenden Temperaturschritte, die zur Ausdiffusion aus Emitter- und Basisanschluß notwendig sind, durchgeführt werden.

Figur 13: Vor dem Aufbringen einer ganzflächigen Isolationsschicht 16, zum Beispiel aus SiO₂, erfolgt die Aktivierung der Emitter- 35 und Basisdiffusionszonen 36 aus den Ätzresiduen 11a, 11b und den direkt auf der Substratoberfläche (3) liegenden Schichtstrukturen 13a, 13b bei 950°C 30 Minuten lang.

Figur 14: Die völlig selbstjustierte Bipolartransistorstruktur, bei der Emitterbreiten im Bereich von 0,2 bis 0,5 µm realisierbar sind, wird fertiggestellt durch Einbringen der Kontaktlöcher in die Isolationsschicht 16, Durchführung einer zum Beispiel aus Aluminium bestehenden Metallisierung und Strukturierung der Emitter- 17b und Kollektor-Kontakte 17a, 17c. Der Basiskontakt ist in Figur 14 nicht sichtbar.

Figur 15 zeigt die Variante der erfindungsgemäßen Bipolartransistorstruktur, bei der die Basisanschlüsse (Schicht 13) nach oben und der Emitteranschluß seitlich kontaktiert wird. Dabei ist mit dem Bezugszeichen 13c der linke Basiskontakt und mit 13a der rechte Basiskontakt bezeichnet.

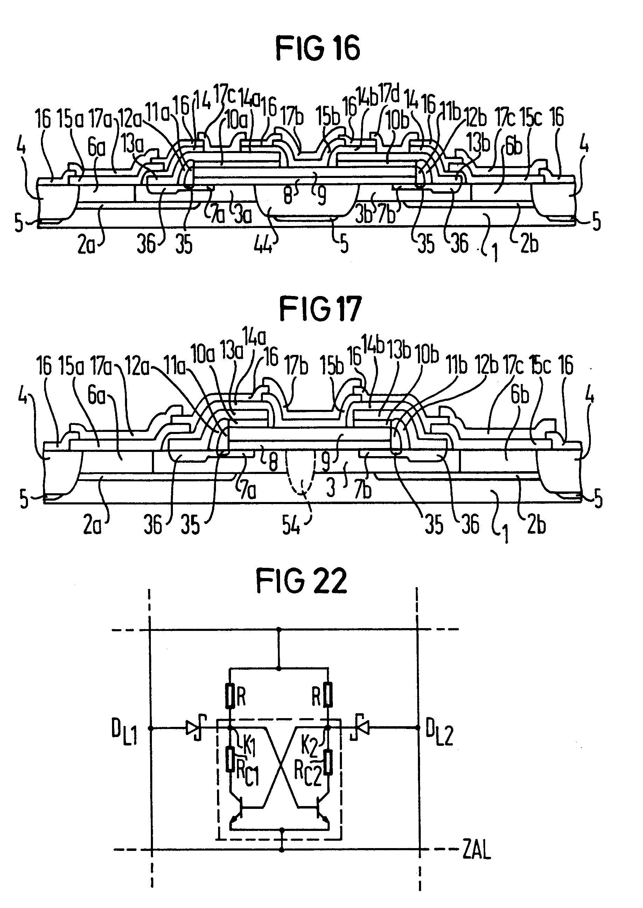

Figur 16: Es gelten die gleichen Bezugszeichen wie in den Figuren 1 bis 15. Mit dem Bezugszeichen 44 ist das die beiden Transistoren trennende Isolationsgebiet bezeichnet, welches bei der Herstellung der Feldoxidbereiche 4 mit erzeugt wird. Die Struktur enthält getrennte Kollektoren 17a, 17c und 17d, 17e. Mit 17b ist der für das Transistorpaar vorgesehene gemeinsame Emitteranschluß bezeichnet. Die hier abgebildete Transistorstruktur zeichnet sich dadurch aus, daß die Emitter mit ihren Breiten im Bereich von 0,3 µm weitgehend identisch sind und über dem Emitteranschluß 17b intern miteinander verbunden sind. Dieses war bislang für die meisten CML-Logik-Schaltungen nur mit externer Verdrahtung möglich. Basis- und Emitterbereich sind selbstjustierend hergestellt.

Figur 17 zeigt bipolare Speicherzellen mit gemeinsamen Emitter 17b und nur einem einzigen Isolationsring 4 pro Speicherzelle, was einen minimalen Flächenbedarf bedeutet. Die Isolation zwischen den beiden Kollektoren 17a, 17c ist bei einer hochohmigen Epitaxieschicht 3 ausreichend. Zur Verminderung bzw. Unterdrückung des Querstromes kann eine zusätzliche Isolationsmaßnahme, zum Beispiel eine Grabenisolationsschicht 54 eingefügt werden, welche bei der Herstellung der Feldoxidbereiche 4 mit erzeugt wird. Weiter wird ein Emitterkontakt bezüglich herkömmlichen Strukturen gespart, da beide Emitter intern verbunden sind.

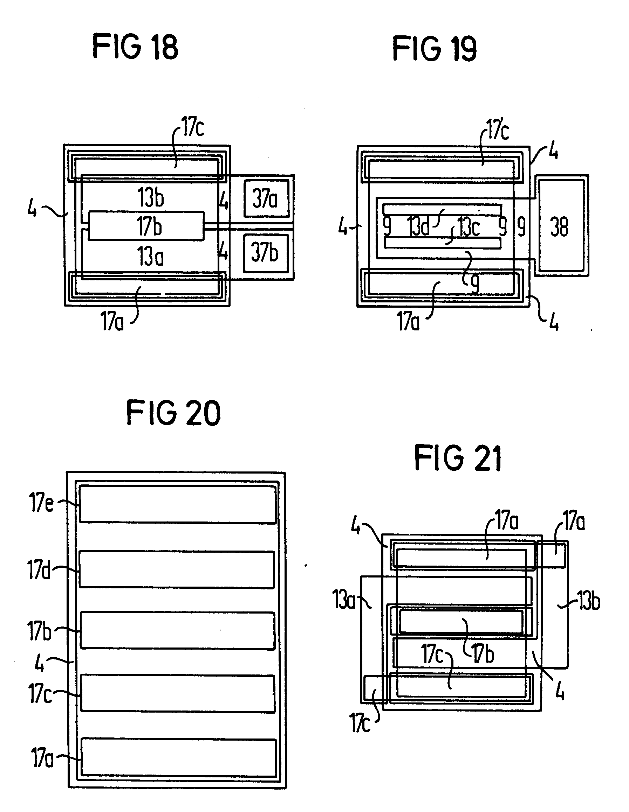

Figur 18: Die in Draufsicht dargestellte Einzeltransistorstruktur nach Figur 14 zeigt die seitlich angeordneten Basis-Kontaktlöcher 37a, 37b. Ansonsten gelten die gleichen Bezugszeichen wie in Figur 14.

Figur 19 zeigt die Variante gemäß Figur 15 in Draufsicht, bei der der Emitteranschluß über das Kontaktloch 38 vorgenommen wird.

Figur 20 zeigt die Draufsicht der Struktur des Transistorpaares gemäß Figur 16.

Figur 21 zeigt die Draufsicht der Speicherzellenstruktur gemäß Figur 17. Die Kontaktierung 17a, 17c stellt die nötigen Verbindungen von den Basiszonen zu der entsprechenden Kollektoren her, wobei diese Kontaktierungen über den Kollektor hinaus bis über die herausgeführten Basisanschlüsse geht und somit die kreuzweise Verbindung der Basen mit den Kollektoren gemäß Figur 22 herstellt. Hierbei erspart man sich zwei Basiskontakte.

Figur 22 zeigt das Schaltbild einer Speicherzelle mit Schottky-Dioden-Kopplung, wobei der strichlierte Bereich durch das erfindungsgemäße Verfahren hergestellt wird. Rc1 und Rc2 ergeben sich automatisch bei der Herstellung der Kollektoranschlüsse. Die Knoten K1 und K2 ergeben sich durch Überlappung der Kollektorkontakte 17a bzw. 17c mit denentsprechenden Basisanschlüssen. Mit DL₁ und DL₂ ist die Datenleitung, mit ZAL die Zeilenauswahlleitung bezeichnet.

Die hauptsächlichen Vorteile der beschriebenen Transistorstrukturen und der dazugehörigen Herstellungsfolgen sind:
1. Es sind reproduzierbare Emitterbreiten kleiner 1 µm, insbesondere auch kleiner 0,3 µm einstellbar.
2. Die Herstellung ist unabhängig von der Lithographie, was sehr kostengünstig ist.
3. Die drastische Reduktion der parasitären Elemente ergibt höchste Schaltgeschwindigkeiten.
4. Symmetrische Transistorpaare mit gekoppeltem Emitter (ECL-Schaltungen = emitter coupled logic, usw.) sind bei sehr geringem Platzbedarf realisierbar.
5. Speicherzellen mit minimalen Flächenbedarf sind herstellbar.
6. Der Kristallfehler-empfindliche Emitter-Basis-Bereich kommt nicht in Berührung mit dem Isolationsgebiet zwischen den verschiedenen Bauelementen; dadurch ist ein großer Ausbeutevorteil gegeben und die Strukturen sind für hochkomplexe VLSI-Schaltungen geeignet.
7. Es sind keine maskenaufwendigen und komplizierten Prozeßschritte erforderlich.

## Patentansprüche

1. Verfahren zum Herstellen einer Bipolartransistorstruktur, bei dem folgende Schritte nacheinander durchgeführt werden:
a) Abscheidung einer epitaktischen Schicht (3) von einem zweiten Leitungstyp auf ein Siliziumsubstrat (1) von einem ersten entgegengesetzten Leitungstyp,
b) Erzeugung von Isolationsbereichen (4, 44, 54) aus dielektrischem Material in der epitaktischen Schicht (3) und im Siliziumsubstrat (1) zur Trennung von aktiven Transistorbereichen,
c) Erzeugung einer Basiszone (7a, 7b) durch maskierte Implantation von Ionen (32) des ersten Leitungstyps in die epitaktische Schicht (3) vom zweiten Leitungstyp,
d) Herstellung einer Schichtenfolge durch ganzflächige Abscheidung eines ersten Isolationsmaterials (8), eines leitfähigen Materials (9) vom zweiten Leitungstyp und eines zweiten Isolationsmaterials (10),
e) Strukturierung der Schichtenfolge (8, 9, 10) aus erstem und zweitem Isolationsmaterial und dazwischenliegendem leitfähigem Material durch einen anisotropen Ätzprozeß nach erfolgter Maskierung so, daß die Schichtenstruktur (8, 9, 10) den Bereich der Oberfläche des Substrats abdeckt, über dem der spätere Emitteranschluß gebildet wird, und sich über einen Teil der Basiszone (7a, 7b) erstreckt,
f) ganzflächige Abscheidung einer die Schichtenstrukturen (8, 9, 10) gut kantenbedeckenden Schicht (11) aus leitfähigem und als Diffusionsquelle verwendbarem Material vom zweiten Leitungstyp in einer Schichtdicke, die abzüglich des thermisch aufgewachsenen Oxids der gewünschten Emitterbreite (35) der Transistorstruktur entspricht, und anisotrope Rückätzung dieser Schicht (11) zur Erzeugung von Flanken-Ätzresiduen (11a, 11b) an den Schichtenstrukturkanten,
g) Herstellen einer ganzflächigen Isolationsschicht (12) und anisotrope Rückätzung der gebildeten Isolationsschicht (12) zur Erzeugung von Flankenisolationsschichten (12a, 12b) an den Ätzresiduen (11a, 11b),
h) ganzflächige Abscheidung einer Doppelschicht (13, 14) bestehend aus einer ersten Schicht (13) aus leitfähigem und als Diffusionsquelle verwendbarem Material vom ersten Leitungstyp und einer zweiten Isolationsschicht (14) und anisotrope Strukturierung dieser Doppelschicht (13, 14) zur Bildung eines die Basiszone (7a, 7b) kontaktierenden Basisanschlusses (13a, 13b),
i) Abscheiden und Rückätzen einer Isolationsschicht zur Erzeugung von Flankenisolationsschichten an der Basisanschlußschicht (13a, 13b),
j) ganzflächige Abscheidung von leitfähigem Material (15) vom zweiten Leitungstyp und Strukturierung dieser Schicht zur Bildung eines Emitteranschlusses (15b) und eines Kollektoranschlusses (15a, 15c),
k) Durchführung eines Temperschrittes zur Herstellung einer Emitterdiffusionszone (35) durch Ausdiffusion aus den Flanken-Ätzresiduen (11a, 11b) und einer Basisdiffusionszone (36) durch Ausdiffusion aus dem Basisanschluß (13a, 13b) und zur Aktivierung der Emitter- (35) und Basisdiffusionszonen (36),
l) Erzeugung einer als Isolationsoxid dienenden Zwischenschicht (16), Öffnen der Kontaktlöcher zu den Emitter-, Basis- und Kollektoranschlußbereichen und Durchführung der Metallisierung (17) in bekannter Weise.

2. Verfahren nach Anspruch 1, **dadurch gekennzeichnet,** daß zur Erzeugung eines tiefreichenden Kollektoranschlusses vor dem Verfahrensschritt a) durch Implantation oder Belegung von Dotierstoff vom zweiten Leitungstyp im Bereich des späteren Kollektoranschlusses (17a, 17c) eine vergrabene Zone (2a, 2b) erzeugt wird und daß vor dem Verfahrensschritt c) durch Implantation oder Belegung von Dotierstoff vom zweiten Leitungstyp eine niederohmige Verbindung (6a, 6b) zu der vergrabenen Zone (2a, 2b) hergestellt wird.

3. Verfahren nach Anspruch 1 oder 2, **dadurch gekennzeichnet,** daß nach Verfahrensschritt d) eine dritte, aus Siliziumnitrid bestehende Isolationsschicht (34) aufgebracht wird, welche vor dem Verfahrensschritt g) entfernt wird.

4. Verfahren nach einem der Ansprüche 1 bis 3, **dadurch gekennzeichnet,** daß die Herstellung der Isolationsbereiche (4, 44, 54) gemäß Verfahrensschritt b) durch Grabenätzung und Auffüllung der Gräben mit dielektrischem Material erfolgt.

5. Verfahren nach Anspruch 4, **dadurch gekennzeichnet,** daß zur Erzeugung von Kanal-Stopper-Bereichen (5) beim Verfahrensschritt b) in die für die Abscheidung des dielektrischen Materials (4, 44) geöffneten Gräben eine maskierte Implantation von Ionen des ersten Leitungstyps durchgeführt wird.

6. Verfahren nach einem der Ansprüche 1 bis 5, **dadurch gekennzeichnet,** daß als erstes (8) und zweites Isolationsmaterial (10) gemäß Verfahrensschritt d) und als Isolationsmaterial (12, 14, 16) gemäß den Verfahrensschritten g), h), i) und l) Siliziumoxid (SiOₓ) verwendet wird.

7. Verfahren nach einem der Ansprüche 1 bis 6, **dadurch gekennzeichnet,** daß als leitfähiges Material (9, 11, 13, 15) gemäß Verfahrensschritt d), f), h) und j) mit der entsprechenden Dotierung versehenes Polysilizium, Polysilizium mit Metallsilizid, Metallsilizid aus einem hochschmelzenden Metall oder ein hochschmelzendes Metall verwendet wird.

8. Verfahren nach einem der Ansprüche 1 bis 7, **dadurch gekennzeichnet,** daß die Ätzprozesse gemäß den Verfahrensschritten e), f), g), h), i) Trockenätzprozesse, vorzugsweise reaktive Ionenätzprozesse, sind.

9. Verfahren nach einem der Ansprüche 1 bis 8, **dadurch gekennzeichnet,** daß die Aktivierung der Emitter- und Basisdiffusionszonen (35, 36) im Verfahrensschritt k) im Temperaturbereich von 900 - 1000°C in 30 Minuten durchgeführt wird.

10. Verfahren nach einem der Ansprüche 1 bis 9, **dadurch gekennzeichnet,** daß die Herstellung der Isolationsschicht (12) gemäß Verfahrensschritt g) durch selektive thermische Oberflächenoxidation erfolgt.

11. Verfahren nach einem der Ansprüche 1 bis 10, **dadurch gekennzeichnet,** daß die Verfahrensschritte j) und l) so geführt werden, daß der Emitteranschluß seitlich und der Basisanschluß nach oben kontaktiert wird.

12. Verfahren nach einem der Ansprüche 1 bis 11, **dadurch gekennzeichnet,** daß der Verfahrensschritt k) vor dem Verfahrensschritt j) durchgeführt wird und daß anstelle der Abscheidung des leitfähigen Materials vom zweiten Leitungstyp die Metallisierung durchgeführt wird.

## Claims

1. Method for producing a bipolar transistor structure, in which the following steps are carried out in succession:
a) deposition of an epitaxial layer (3) of a second conduction type on a silicon substrate (1) of a first, opposite conduction type,
b) creation of insulation regions (4, 44, 54) composed of dielectric material in the epitaxial layer (3) and in the silicon substrate (1) to isolate active transistor regions,
c) creation of a base zone (7a, 7b) by masked implantation of ions (32) of the first conduction type in the epitaxial layer (3) of the second conduction type,
d) production of a layer sequence by deposition, over the entire surface, of a first insulation material (8), a conductive material (9) of the second conduction type and a second insulation material (10),
e) after carrying out masking, patterning the layer sequence (8, 9, 10) comprising first and second insulation material and conductive material situated in between by an anisotropic etching process in such a way that the layer structure (8, 9, 10) covers the region of the surface of the substrate above which the subsequent emitter terminal is formed and extends over a part of the base zone (7a, 7b),
f) deposition, over the entire surface, of a layer (11) having good edge coverage of the layer structures (8, 9, 10) and composed of a conductive material of the second conduction type which can be used as diffusion source, in a layer thickness which corresponds to the desired emitter width (35) of the transistor structure less the thermally grown oxide and anisotropic back-etching of said layer (11) to create edge etching residues (11a, 11b) at the layer structure edges,
g) production of an insulation layer (12) over the entire surface and anisotropic back-etching of the insulation layer (12) formed to create edge insulation layers (12a, 12b) at the etching residues (11a, 11b),
h) deposition, over the entire surface, of a double layer (13, 14) comprising a first layer (13) of conductive material which can be used as a diffusion source and is of the first conduction type and a second insulation layer (14) and anisotropic patterning of said double layer (13, 14) to form a base terminal (13a, 13b) which makes contact to the base zone (7a, 7b),
i) deposition and back etching of an insulation layer to create edge insulation layers at the base terminal layer (13a, 13b),
j) deposition, over the entire surface, of conductive material (15) of the second conduction type and patterning of said layer to form an emitter terminal (15b) and a collector terminal (15a, 15c),
k) carrying out of a heat-treatment step to produce an emitter diffusion zone (35) by outdiffusion from the edge etching residues (11a, 11b) and a base diffusion zone (36) by outdiffusion from the base terminal (13a, 13b) and to activate the emitter (35) and base diffusion zones (36),
l) creation of an interlayer (16) which serves as insulation oxide, opening of the contact vias to the emitter, base and collector terminal regions and carrying out of the metallisation (17) in a known manner.

2. Method according to Claim 1, characterised in that, to create a deep-reaching collector terminal, a buried zone (2a, 2b) is created prior to the method step a) by implantation of, or coating with, dopant of the second conduction type in the region of the subsequent collector terminal (17a, 17c), and in that, prior to the method step c), a low-resistance connection (6a, 6b) to the buried zone (2a, 2b) is made by implantation of, or coating with, dopant of the second conduction type.

3. Method according to Claim 1 or 2, characterised in that, after method step d) a third insulation layer (34) is deposited which comprises silicon nitride and which is removed prior to the method step g).

4. Method according to one of Claims 1 to 3, characterised in that the insulation regions (4, 44, 54) in accordance with method step b) are produced by trench etching and filling the trenches with dielectric material.

5. Method according to Claim 4, characterised in that a masked implantation of ions of the first conduction type in the trenches opened for the deposition of the dielectric material (4, 44) is carried out to create channel-stopper regions (5) in method step b).

6. Method according to one of Claims 1 to 5, characterised in that silicon oxide (SiOₓ) is used as first (8) and second insulation material (10) according to method step d) and as insulation material (12, 14, 16) according to method steps g), h), i) and l).

7. Method according to one of Claims 1 to 6, characterised in that polysilicon provided with the appropriate doping, polysilicon together with metal silicide, metal silicide of a refractory metal or a refractory metal is used as conductive material (9, 11, 13, 15) according to method step d), f), h) and j).

8. Method according to one of Claims 1 to 7, characterised in that the etching processes according to the method steps e), f), g), h), i) are dry etching processes, preferably reactive ion etching processes.

9. Method according to one of Claims 1 to 8, characterised in that the activation of the emitter and base diffusion zones (35, 36) in method step k) is carried out in 30 minutes in the temperature range of 900-1000°C.

10. Method according to one of Claims 1 to 9, characterised in that the insulation layer (12) according to method step g) is produced by selective thermal surface oxidation.

11. Method according to one of Claims 1 to 10, characterised in that the method steps j) and l) are carried out in such a way that contact is made to the emitter terminal laterally and to the base terminal in the upward direction.

12. Method according to one of Claims 1 to 11, characterised in that the method step k) is carried out prior to the method step j), and in that the metallisation is carried out instead of depositing the conductive material of the second conduction type.

## Revendications

1. Procédé pour fabriquer une structure de transistor bipolaire, selon lequel on met en oeuvre successivement les étapes suivantes :
a) dépôt d'une couche épitaxiale (3) possédant un second type de conductivité, sur un substrat en silicium (1) possédant un premier type de conductivité opposé,
b) production de régions isolantes (4,44,54) réalisées en un matériau diélectrique dans la couche épitaxiale (3) et dans le substrat en silicium (1) pour la séparation de régions actives du transistor,
c) production d'une zone de base (7a,7b) par implantation masquée d'ions (32) possédant le premier type de conductivité dans la couche épitaxiale (3) possédant le second type de conductivité,
d) fabrication d'une succession de couches par dépôt, sur toute la surface, d'un premier matériau isolant (8), d'un matériau conducteur (9) possédant le second type de conductivité et d'un second matériau isolant (10),
e) structuration de la suite de couches (8,9,10) formée de premier et second matériaux isolants et d'un matériau conducteur intercalé, au moyen d'un procédé de corrosion anisotrope après exécution d'un masquage de sorte que la structure à couches (8,9,10) recouvre la zone de la surface du substrat, au-dessus de laquelle est formée ultérieurement la borne d'émetteur, et s'étend au-dessus d'une partie de la zone de base (7a,7b),
f) dépôt, sur toute la surface, d'une couche (11) qui recouvre bien les bords des structures à couches (8,9,10) et est réalisée en un matériau conducteur, qui est utilisable en tant que source de diffusion et possède le second type de conductivité, le dépôt s'effectuant sur une épaisseur de couche qui, déduction faite de l'oxyde formé par croissance thermique, correspond à la largeur désirée (35) de l'émetteur de la structure du transistor, et rétrocorrosion anisotrope de cette couche (11) pour former des résidus de corrosion (11a,11b) des flancs au niveau des bords de la structure à couches,
g) fabrication d'une couche isolante (12) sur toute la surface et rétrocorrosion anisotrope de la couche isolante formée (12) pour la production de couches (12a,12b) d'isolation des flancs sur les résidus de corrosion (11a,11b),
h) dépôt, sur toute la surface d'une couche double (13,14) constituée par une première couche (13) réalisée en un matériau conducteur et utilisable en tant que source de diffusion et possédant le premier type de conductivité, et par une seconde couche isolante (14), et structuration anisotrope de cette couche double (13,14) pour former une borne de base (13a,13b), qui est en contact avec la zone de base (7a,7b),
i) dépôt et rétrocorrosion d'une couche isolante pour la formation de couches isolantes des flancs sur la couche (13a,13b) de la borne de base,
j) dépôt sur toute la surface d'un matériau conducteur (15) possédant le second type de conductivité et structuration de cette couche pour la formation d'une borne d'émetteur (15b) et d'une borne de collecteur (15a,15c),
k) exécution d'une étape de recuit pour fabriquer une zone de diffusion de l'émetteur (35) par diffusion à partir des résidus de corrosion (11a,11b) des flancs, et une zone de diffusion de base (36) par diffusion à partir de la borne de base (13a,13b) et pour l'activation de la zone de diffusion d'émetteur (35) et de la zone de diffusion de base (36),
l) production d'une couche intermédiaire (16) utilisée en tant qu'oxyde isolant, ouverture des trous de contact aboutissant aux zones d'émetteur, de base et de collecteur et application de la métallisation (17) de façon connue.

2. Procédé suivant la revendication 1, caractérisé par le fait que pour la production d'une borne de collecteur profonde, avant l'étape opératoire a), on forme une zone ensevelie (2a,2b) avant l'étape opératoire a) par implantation ou dépôt d'une substance dopante possédant le second type de conductivité dans la zone de la borne de collecteur (17a,17b) formée ultérieurement, et qu'avant l'étape opératoire c) on forme, par implantation ou dépôt d'une substance dopante possédant le second type de conductivité, une liaison de faible valeur ohmique (6a,6b) avec la zone ensevelie (2a,2b).

3. Procédé suivant la revendication 1 ou 2, caractérisé par le fait qu'après l'étape opératoire d), on dépose une troisième couche isolante (34) formée de nitrure de silicium, qu'on élimine avant l'étape opératoire g).

4. Procédé suivant l'une des revendications 1 à 3, caractérisé par le fait que la fabrication des régions isolantes (4,44,54) s'effectue conformément à l'étape opératoire (b) par formation de sillons par corrosion et remplissage des sillons par un matériau diélectrique.

5. Procédé suivant la revendication 4, caractérisé par le fait que pour la production de régions d'arrêt de canal (5), lors de l'étape opératoire b), on exécute une implantation masquée d'ions possédant le premier type de conduction dans les sillons ouverts pour le dépôt du matériau diélectrique (4,44).

6. Procédé suivant l'une des revendications 1 à 5, caractérisé par le fait qu'on utilise de l'oxyde de silicium (SiOₓ) comme premier matériau isolant (8) et second matériau isolant (10) conformément à l'étape opératoire d) et en tant que matériau isolant (12,14,16) conformément aux étapes opératoires g), h), i) et l).

7. Procédé suivant l'une des revendications 1 à 6, caractérisé par le fait qu'on utilise, comme matériau conducteur (9,11,13,15) conformément aux étapes opératoires d), f), h) et j), du polysilicium comportant le dopage correspondant, du polysilicium comportant un siliciure métallique, un siliciure métallique provenant d'un métal à point de fusion élevé ou un métal à point de fusion élevé.

8. Procédé suivant l'une des revendications 1 à 7, caractérisé par le fait que les processus de corrosion conformes aux étapes opératoires e), f), g), h), i) sont des processus de corrosion par voie sèche, de préférence des processus de corrosion ionique réactive.

9. Procédé suivant l'une des revendications 1 à 8, caractérisé par le fait que l'activation des zones de diffusion d'émetteur et de base (35,36) est exécutée lors de l'étape opératoire k) dans une plage de températures de 900-1000°C en 30 minutes.

10. Procédé suivant l'une des revendications 1 à 9, caractérisé par le fait que la fabrication de la couche isolante (12) conformément à l'étape opératoire g) s'effectue au moyen d'une oxydation thermique sélective superficielle.

11. Procédé suivant l'une des revendications 1 à 10, caractérisé par le fait que les étapes opératoires j) et l) sont exécutées de manière à établir un contact latéral avec la borne d'émetteur et un contact à la partie supérieure de la borne de base.

12. Procédé suivant l'une des revendications 1 à 11, caractérisé par le fait que l'étape opératoire k) est exécutée avant l'étape opératoire j) et qu'à la place du dépôt du matériau conducteur possédant le second type de conductivité, on exécute la métallisation.
